# EUROPEAN PATENT APPLICATION

(11) **EP 1 300 920 A1**
(43) Date of publication of application: **09.04.2003**
(21) Application number: 01402590.2
(22) Date of filing: 08.10.2001
(51) Int. Cl.: H02J 7/00, G01R 31/36

(54) **Device and method for electrical battery type recognition**

(71) Applicant: Thomson Licensing S.A., 92648 Boulogne Cedex (FR)
(72) Inventor: Tse, Lawrence, Tsuen Wan, New Territories, Hong Kong (CN); Au, Matthew, Flat F, 14/f, Belleve Court, Shattin, New Territories, Hong Kong (CN); Leung, Franken, North Point, Hong Kong (CN); Lit, Yuen Shing, c/o Thomson Audio Hong Kong, Sin Lek Yuen, Shatin, Hong Kong (CN)
(74) Representative: Rossmanith, Manfred, Dr.

(57) **Abstract**

The present invention relates to a device and a method for electrically recognizing if a battery is of a rechargeable or non-rechargeable type. The invention is also related to a portable electronic device equipped with a charging device according to the invention.

The inventive devices and the method of the invention allow the detection of the battery type in a simple and very economic way by measuring the actual charging current and comparing it with a predetermined reference value. As the charging currents of primary and secondary batteries display a completely different behavior the discrimination of the two battery types is readily achieved. Additional circuitry for measuring the actual battery voltage is not required for this purpose.

## Description

### Field of the invention

The present invention relates to a device for charging a battery. In particular the invention is related to a charging device capable of recognizing the type of the battery according to independent claim 1. A second aspect of the invention is related to a method for electrical battery type recognition according to independent claim 4. Yet a third aspect of the invention is related to a portable electronic device being equipped with the inventive charging device.

### Background of the invention

In the following, the problem underlying the present invention will be discussed in more detail with respect to the use of rechargeable batteries in portable CD players for illustrative purposes only. However, it is well understood for a person skilled in the art that instead of a portable CD player any other device making use of a feature to recharge batteries could be used for implementing the present invention as set out further below.

In order to give mobility to its user it is common for a personal portable CD player (a so-called "discman") to rely on a power source in the form of batteries that are inserted in the housing of said CD player to provide the electrical power necessary for the operation of the CD player and to make the user independent from stationary power sources such as plug-in devices with which the CD player is connected to stationary electrical power networks. It is furthermore common for personal CD players, particularly for so-called "high-end range products" with improved user friendliness and quality to have integrated a recharge feature to give the user the possibility to make use of rechargeable batteries because the long-term operation of such rechargeable batteries is less expensive than the use of non-rechargeable batteries which have to be regularly replaced by new batteries once they are exhausted.

In order to have a fast (re-)charging capability a high charging current is needed in such a recharging feature integrated in the battery compartment of a personal CD player.

Most manufacturers in the market require users to use predetermined special types of rechargeable batteries (so-called "secondary batteries") either in a battery type pack format or a battery without sleeve near the negative terminal for battery type detection. With this approach either a mechanical detector switch or a metal plate to contact the negative terminal (the area without sleeve) is needed. However, it is usually difficult to buy this kind of special batteries on the street. In order to overcome this problem manufacturers of portable CD players usually manufacture their products in such a way that no special features are integrated in the housing of their CD players.

However, if normal rechargeable batteries can be used, the user has also the option to insert standard non-rechargeable batteries (so-called "primary batteries") as well into the battery compartment of the portable CD player. Thus, there is a need to find a way to identify the type of batteries which are inserted into the battery compartment of a portable CD player without using mechanical parts to avoid a situation where non-rechargeable batteries are charged by the recharging features integrated in the battery compartment of the CD player.

In particular the present invention relates to a device and a method for electrical battery type recognition which allow to determine if a battery is of a rechargeable or a non-rechargeable battery type.

Devices and methods for electrical battery type recognition according to the preambles of the independent claims are for example known from US 5,847,539 and US 6,043,625.

In US 5,847,539 there is described a method according to which the voltage produced by a battery inserted into a recharging compartment of an electrical appliance is detected by voltage sensing means and then based upon the detected voltage value it is decided whether said battery is of a rechargeable or non-rechargeable type before an actual recharging current is pumped into a rechargeable type battery only.

In US 6,043,625 there is disclosed a method according to which a voltage produced by a battery inserted into a recharging compartment of an electrical appliance is detected and compared to a predetermined reference voltage. The result of this comparison will determine whether said battery is rechargerable or not. The method employed wherein also detects polarity of said battery.

The above mentioned known devices and methods for electrical battery type recognition are based upon electrically sensing and comparing voltages and require rather complex and expensive circuitry.

### Summary of the invention

Accordingly, it is desirable to overcome the above mentioned disadvantages known from the prior art devices and methods for electrical battery type recognition.

The inventive device for charging a battery comprises means for setting a predetermined charging voltage; means for generating a feedback signal of an actual charging current; means for generating a reference signal of a charging current; first comparison means for comparing said feedback signal of the actual charging current with the reference signal of the charging current and for generating an output signal indicative of a chargeable or non-chargeable battery; and means to interrupt the limited constant charging voltage or maintain said properly predetermined limited constant charging voltage as a function of the output signal of the comparison means.

The inventive method for electrically recognizing if a battery is of a chargeable or non-chargeable type comprises the following steps: setting a predetermined charging voltage; detecting a feedback signal of an actual charging current from a battery to be recharged; generating a reference signal representative of a desired charging current; comparing said feedback signal of the actual charging current with the reference signal to determine, if the predetermined charging voltage is to be interrupted or maintained.

The concept underlying the present invention is rather simple and cost effective.

It is observed that different types of batteries can intake different levels of charging current at their different capacity levels. By comparing a high constant charging current as a reference with the actual charging current that is being pumped into the batteries it is therefore possible to identify whether the batteries are rechargeable or not.

A truly rechargeable battery ("secondary battery") can be charged with a high constant current despite of its current charging level.

In contrast thereto, a primary battery which is not truly rechargeable, such as for example an alkaline or a carbon zinc battery, can only be charged with a high constant current for a very short period of time depending on the current capacity level that said primary battery has at a given moment. Therefore, the amount of current that can be pumped into such a primary battery will slowly reduce after some time if the applied charging voltage is fixed at a predetermined value.

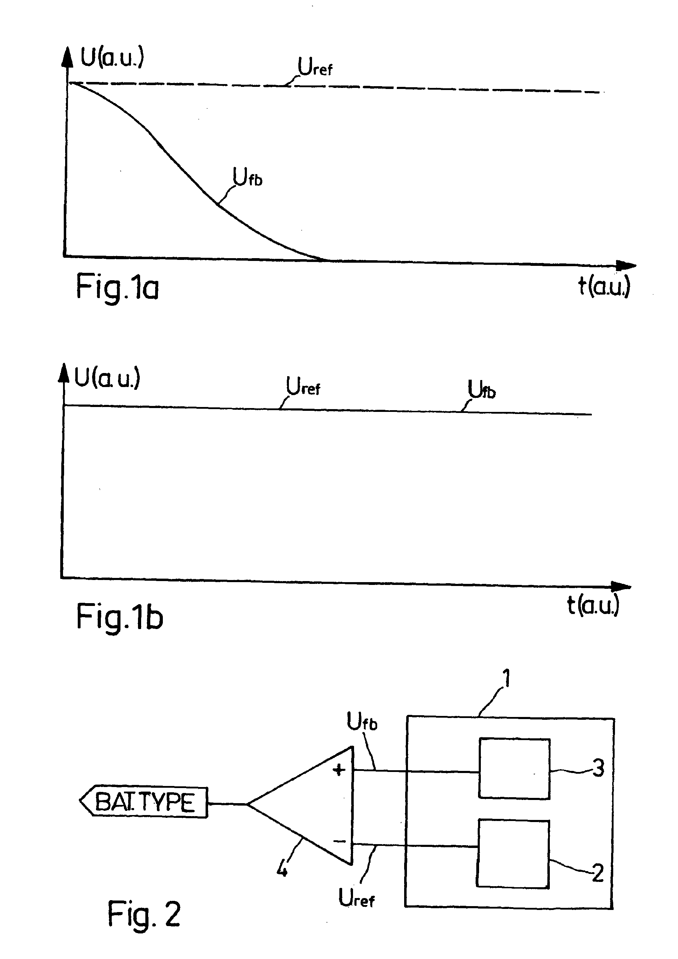

This difference in the time-dependent (re-)charging characteristics of a primary and a secondary battery is schematically depicted in Figs. 1a and 1b.

When the applied constant charging voltage is limited to a predetermined value, the feedback signal U_{fb} corresponding to the actual charging current will very soon be lower than the desired reference charging current when an attempt is made to recharge a non-rechargeable ("primary") battery.

The dotted line in Fig. 1a corresponds to the reference signal U_{ref} of the charging current in a recharging unit for batteries to which a constant charging voltage is applied. The solid line in Fig. 1a shows a feedback signal U_{fb} corresponding to an actual charging current. It is evident that for a primary battery said actual charging current drops off quite quickly when an attempt is made to recharge said primary battery with a given constant charging voltage.

Fig. 1b also shows a straight solid line corresponding to the reference signal U_{ref} of the charging current in a recharging unit for secondary batteries to which a constant charging voltage is applied. This solid line in Fig. 1b also corresponds to a feedback signal U_{fb} corresponding to an actual charging current, i.e. in this situation the actual charging current always corresponds to the desired/reference charging current.

However, for a rechargeable ("secondary") battery the feedback signal U_{fb} remains the same as the desired reference charging current if the applied constant charging voltage is set properly.

Accordingly, by applying a predetermined fixed charging voltage level and comparing the measured charging current and the desired charging current one can determine whether the inserted batteries are chargeable or not.

A typical constant current charger usually needs to monitor the actual charging current by a feedback signal U_{fb} to perform a regulation of the charging process.

Thus by providing a comparator and by using the already existing desired reference charging current and the feedback signal U_{fb} it can be determined if a battery inserted into a detection device according to the present invention is indeed rechargeable or not.

In the same way, the present invention employs the typical constant current regulation circuit. But at the same time the present invention also uses a feedback signal U_{fb} to determine whether the battery is rechargeable or not.

The concept underlying the present invention does not take into consideration the battery voltage as such for it only senses the actual charging current. Therefore, according to the present invention sensing of the battery voltage is not needed to detect the battery type. The battery voltage is only utilized to terminate the charging operation of a chargeable battery as it will be described further below.

Further advantages and features of the device and method according to the invention may be taken from the following detailed description of preferred embodiments in conjunction with the drawings.

### Brief description of the drawings

Fig. 1a and 1b show a comparison between the charging current characteristics of a rechargeable, secondary battery and a non-rechargeable, primary battery.
Fig. 2 is a schematic block diagram for illustrating the principle of battery type detection which is underlying the present invention;
Fig. 3 is a more detailed schematic presentation of an actual circuit used for battery type detection according to the present invention; and

### Description of the preferred embodiments

Fig. 2 shows a schematic block diagram of a battery charging circuit for illustrating according to the present invention. Fig. 2 particularly exemplifies the principle of battery type detection.

The circuit comprises a constant current regulator 1 providing a properly predetermined limited constant charging voltage generating an associated charging current.

The constant current regulator 1 further comprises means 2 for generating a reference signal U_{ref} of the charging current as well as means 3 for generating a feedback signal U_{fb} of an actual charging current.

From the constant current regulator 1 both the reference signal U_{ref} of the charging current as well as the actual current feedback signal U_{fb} are outputted to input terminals of a comparator 4. In the comparator 4 the actual charging current feedback signal U_{fb} is compared with the reference signal U_{ref} of the charging current.

Based on the result of said comparison the comparator 4 outputs a first predetermined signal designated "BAT TYPE" (e.g. a logical high level signal) if the two input signals, i.e. the actual charging current feedback signal U_{fb} and the reference signal U_{ref} of the charging current are the same (corresponding to the situation depicted in Fig. 1b for a rechargeable secondary battery) or a second predetermined signal (e.g. a logical low level signal) if the two input signals, i.e. the actual charging current feedback signal U_{fb} and the reference signal U_{ref} of the charging current are different (corresponding to the situation depicted in Fig. 1a for a non-rechargeable primary battery).

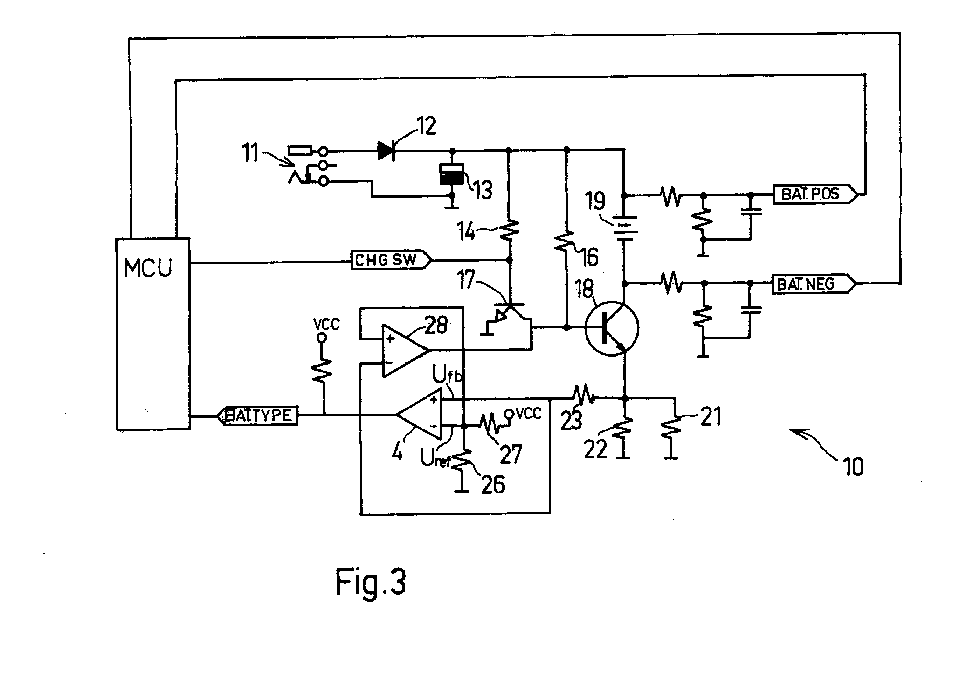

The "BAT_TYPE" output signal is indicative of the battery type to be recharged. In case the "BAT_TYPE" signal is indicative of a primary battery the charging of the battery will be interrupted. If, however, the "BAT_TYPE" signal is indicative of a secondary battery the battery will be charged. The details of the operation will become apparent by reading the description of the more detailed circuit diagram shown in Fig. 3.

Fig. 3 is a more detailed schematic presentation of an actual circuit used for battery type detection according to the present invention.

A charging system 10 comprises a DC jack 11 which is connectable to a DC power input. A diode 12 protects the circuit against applying a voltage of the wrong polarity. Capacitor 13 filters the voltage supplied by the diode 12.

Resistors 14 and 16 limit the current flowing to the bases of transistors 17 and 18 serving as switches to control the actual charging current flowing through battery 19 to be recharged. The output signal "BAT_TYPE" of the comparator 4 is connected to an input of a system micro controller unit MCU to determine whether charging is allowed or not. The MCU controls the output of the charging current by means of the "CHG_SW" signal. If "CHG_SW" is at a logical high level, the base of transistor 17 is switched on and a current may flow through transistor 18 to switch on the transistor 18 so that a charging current may flow through the battery 19 to be recharged in the charging circuit.

In the embodiment shown in Fig. 3 the comparator 4 again is used to generate the "BAT_TYPE" signal that has already been described in connection with Fig. 2. The resistor network of resistors 21, 22 and 23 is connected to the emitter of the transistor 18 and the non-inverting input of comparator 4. By means of the resistor network the feedback signal U_{fb} of the actual charging current is generated. This feedback signal U_{fb} is compared to the reference signal U_{ref} of the charging current generated by resistors 26 and 27 and connected to the inverting input of comparator 4. Hence, if the feedback signal U_{fb} is smaller than the reference signal U_{ref} the output of comparator 4 goes low.

A second comparator 28 is used to regulate the constant charging current of the system. If the comparator 28 is not balanced, i.e. if the input to the inverting input is not equal to the input to the non-inverting comparator 28 outputs a bias current fed into the current flowing between the collector of transistor 17 and the base of transistor 18, thus controlling the actual recharging current flowing through the battery 12 and the transistor 18.

The actual charging current feedback signal U_{fb} is indicative of the actual charging current flowing through the battery to be recharged.

The positive and negative terminal of the battery 19 are coupled to the MCU and provide input signals indicated as "BAT_POS" and "BAT_NEG", respectively. As soon as the potential difference exceeds a predetermined threshold value the MCU sets the "CHG_SW" signal low and terminates the charging of the battery 19 by turning the transistors 17 and 18 off.

The battery type recognition according to the present invention based on an electronic discrimination approach yields the advantage of simplicity and cost effectiveness.

Finally, it is noted that also embodiments utilizing a partial or complete integrating of the elements of the described circuit are encompassed by the scope of the present invention.

## Claims

1. Device for charging a battery comprising
means for setting a predetermined charging voltage;
means (2) for generating a feedback signal (U_{fb}) of an actual charging current;
means (3) for generating a reference signal (U_{ref}) of a charging current;
first comparison means (4) for comparing said feedback signal (U_{fb}) of the actual charging current with the reference signal (U_{ref}) of the charging current and for generating an output signal (BAT_TYPE) indicative of a chargeable or non-chargeable battery (19); and
means (MCU) to interrupt the limited constant charging voltage or maintain said properly predetermined limited constant charging voltage as a function of the output signal (BAT_TYPE) of the comparison means (4).

2. Device according to claim 1, wherein a second comparison means 28 is provided for also comparing said feedback signal U_{fb} of the actual charging current with said reference signal U_{ref} of the charging current, and for outputting an output current as a function of the input signals (U_{ref}, U_{fb}) to control the actual recharging current flowing through a battery (19) to be recharged.

3. Device according to claim 2, wherein said first and said second comparator (4, 28) are integrated in a single integrated chip package.

4. Method for electrically recognizing if a battery is of a chargeable or non-chargeable type comprising the steps of:
setting a predetermined charging voltage;
detecting a feedback signal (U_{fb}) of an actual charging current from a battery (19) to be recharged;
generating a reference signal (U_{ref}) representative of a desired charging current;
comparing said feedback signal (U_{fb}) of the actual charging current with the reference signal (U_{ref}) to determine, if the predetermined charging voltage is to be interrupted or maintained.

5. Method according to claim 4, which further comprises a step of controlling the actual recharging current flowing through the battery to be recharged based on the result of the comparison of said actual charging current feedback signal U_{fb} to said reference charging current.

6. Portable electronic device equipped with a charging device according to one or several of claims 1 to 3.
